# EUROPEAN PATENT APPLICATION

(11) **EP 4 546 570 A1**
(43) Date of publication of application: **30.04.2025**
(21) Application number: 23825744.8
(22) Date of filing: 09.01.2023
(51) Int. Cl.: H01R 4/66

(54) **GROUNDING STRUCTURE AND ELECTRICAL EQUIPMENT**

(30) Priority: 21.06.2022 CN 202221564114 U
(71) Applicant: Sungrow Power Supply Co., Ltd., Hefei, Anhui 230088 (CN)
(72) Inventor: SHEN, Zhanliang, Hefei, Anhui 230088 (CN); XING, Jun, Hefei, Anhui 230088 (CN)
(74) Representative: Zacco Norway AS
(86) International application number: PCT/CN2023/071181
(87) International publication number: WO 2023/246084

(57) **Abstract**

A grounding structure and electrical equipment. The electrical equipment comprises a case (1) having a grounding requirement and a functional device (2) at least partially disposed outside the case (1); the grounding structure comprises at least one grounding connecting portion (3), and the grounding connecting portion (3) is disposed on the housing wall of the part, located outside the case (1), of the functional device (2); and the housing wall of the functional device (2) is conductively connected to the case (1). According to the grounding structure, in the practical application process, the grounding connecting portion (3) is arranged on the housing wall of the functional device (2), and the housing wall of the functional device (2) is conductively connected to the case (1), so that the grounding requirement of the case (1) of the electrical equipment can be satisfied, the internal space of the case (1) does not need to be occupied, i.e., the safety space between the grounding connecting portion (3) and electrical components in the case (1) does not need to be considered, and thus the miniaturization of the case (1) is facilitated.

## Description

The present application claims the priority to Chinese Patent Application No. 202221564114.5, titled "GROUNDING STRUCTURE AND ELECTRICAL EQUIPMENT", filed with the China National Intellectual Property Administration on Jun. 21, 2022, the entire disclosure of which is incorporated herein by reference.

### FIELD

The present application relates to the technical field of grounding of electrical equipment, and in particular to a grounding structure and electrical equipment.

### BACKGROUND

With the gradually decrease of the cost of electrical equipment such as inverters, combiner boxes, etc., the electrical equipment has become increasingly integrated. In the prior art, the electrical equipment includes an enclosure and an inductor, and the inductor protrudes from the enclosure. A grounding symbol and a grounding connection portion (such as a grounding threaded hole) are provided on the enclosure, where the grounding connection portion is generally embodied as self-clinching standoffs arranged on the enclosure. However, the self-clinching standoffs occupy the space inside the enclosure, which is detrimental to miniaturization of the enclosure.

In summary, a technical problem to be solved by those skilled in the art is that the grounding connection portion occupies the space inside the enclosure of the electrical equipment, which affects the miniaturization of the enclosure.

### SUMMARY

In view of this, a grounding structure and electrical equipment are provided according to the present application, to solve the problem that a grounding connection portion occupies a space inside an enclosure of the electrical equipment, which affects miniaturization of the enclosure.

To achieve the above object, the following technical solutions are provided according to the present application.

A grounding structure, applicable to electrical equipment having an enclosure to be grounded and a functional device, at least part of the functional device being located at an outer side of the enclosure; where
the grounding structure includes at least one grounding connection portion configured to be arranged on a housing wall of the at least part of the functional device located at the outer side of the enclosure; and
the housing wall of the functional device is electrically connected to the enclosure.

In an embodiment, the grounding structure further includes a grounding symbol that is provided on the housing wall of the at least part of the functional device located at the outer side of the enclosure at a position proximate to the grounding connection portion.

In an embodiment, the grounding connection portion is a grounding threaded hole configured to cooperate with a grounding bolt and a grounding cable for connection with the ground, or the grounding connection portion is a grounding screw configured to cooperate with a grounding nut and a grounding cable for connection with the ground.

In an embodiment, the grounding connection portion is arranged at a side of the housing wall of the functional device at a position proximate to a bottom thereof.

In an embodiment, the functional device is a die-casting piece, a machined piece, a 3D-printed piece or a profile piece.

In an embodiment, the grounding connection portion and the functional device are integrally formed into one piece or are separate structures that are fixedly connected.

In an embodiment, at least one of the grounding connection portion and the grounding symbol is configured to be integrally formed into one piece with the functional device.

In an embodiment, the grounding symbol is a protrusion or a recess formed on the housing wall.

In an embodiment, the grounding symbol is provided on the housing wall by stamping, laser marking, labeling or printing.

In an embodiment, the functional device is an inductor housing.

Compared with the descriptions in the background, the grounding structure is applied to the electrical equipment, where the electrical equipment includes the enclosure to be grounded and the functional device, and at least the part of the functional device is arranged at the outer side of the enclosure. The grounding structure includes the at least one grounding connection portion. The at least one grounding connection portion is provided on the housing wall of the part of the functional device outside the enclosure, and the housing wall of the functional device is electrically connected to the enclosure. With this grounding structure, in actual applications, the grounding connection portion is arranged on the housing wall of the functional device, where the housing wall of the functional device is electrically connected to the enclosure. Therefore, the grounding demand of the enclosure of the electrical equipment is satisfied without occupation of an internal space of the enclosure, i.e. there is no need to take the safety space (such as an electrical clearance and a creepage distance) between the grounding connection portion and an electrical device inside the enclosure into consideration, which is beneficial to the miniaturization of the enclosure.

Moreover, electrical equipment is further provided according to the present application, including the grounding structure according to any one of the above solutions. Since the grounding structure has the above technical effects, the electrical equipment having the grounding structure also has corresponding technical effects, which are not described herein.

In an embodiment, the electrical equipment is used for photovoltaic power generation.

### BRIEF DESCRIPTION OF THE DRAWINGS

In order to illustrate embodiments of the present application more clearly, drawings referred to describe the embodiments or the prior art will be briefly described hereinafter. Apparently, the drawings in the following description are only some examples of the present application, and for those skilled in the art, other drawings may be obtained based on these drawings without any creative efforts.
FIG. 1 is a schematic perspective view showing the structure of a grounding connection portion of a grounding structure according to an embodiment of the present application where the grounding connection portion is embodied as a grounding threaded hole;
FIG. 2 is a schematic front view showing the structure of the grounding connection portion of the grounding structure according to the embodiment of the present application where the grounding connection portion is embodied as the grounding threaded hole; and
FIG. 3 is a schematic perspective view showing the structure of a grounding connection portion of a grounding structure according to an embodiment of the present application where the grounding connection portion is embodied as a grounding screw.

Reference numerals:

| | | | |
|---|---|---|---|
| 1 | enclosure, | 2 | functional device, |
| 3 | grounding connection portion, | 4 | grounding symbol. |

### DETAILED DESCRIPTION OF THE EMBODIMENTS

A grounding structure and electrical equipment are provided according to the present application, to solve the problem that a grounding connection portion occupies a space inside an enclosure of electrical equipment, which affects miniaturization of the enclosure.

Technical solutions according to the embodiments of the present application will be described clearly and completely as follows in conjunction with the accompany drawings in the embodiments of the present application. It is obvious that the described embodiments are merely a part of the embodiments according to the present application, rather than all of the embodiments. All the other embodiments obtained by those skilled in the art based on the embodiments in the present application without any creative effort belong to the protection scope of the present application.

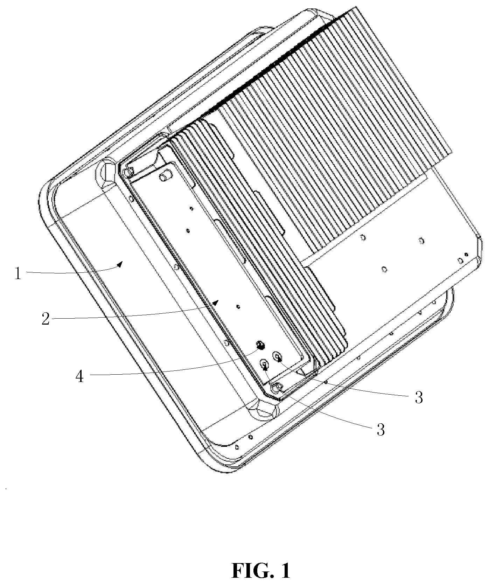

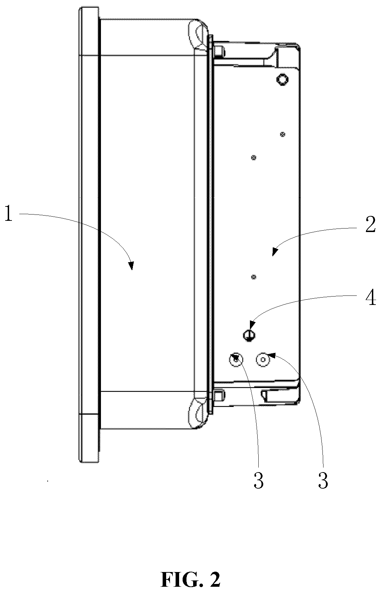

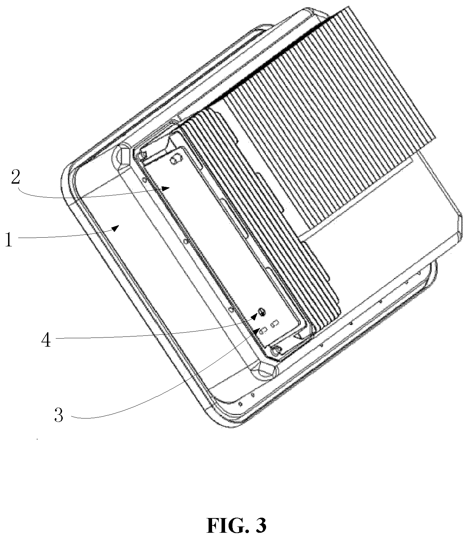

Referring to FIGS. 1 to 3, where FIG. 1 is a schematic perspective view showing the structure of a grounding connection portion of a grounding structure according to an embodiment of the present application where the grounding connection portion is embodied as a grounding threaded hole; FIG. 2 is a schematic front view showing the structure of the grounding connection portion of the grounding structure according to the embodiment of the present application where the grounding connection portion is embodied as a grounding threaded hole; and FIG. 3 is a schematic perspective view showing the structure of a grounding connection portion of a grounding structure according to an embodiment of the present application where the grounding connection portion is embodied as a grounding screw.

A grounding structure applicable to electrical equipment is provided according to an embodiment of the present application. Referring to FIGS. 1 to 3, the electrical equipment includes an enclosure 1 to be grounded and a functional device 2, and at least a part of the functional device 2 is arranged at an outer side of the enclosure 1. Electrical devices are mounted inside the enclosure 1, and are required to be grounded. The functional device 2 is a device that has corresponding functions to make the electrical devices inside the enclosure 1 better operated. Specifically, the functional device 2 may be an inductor housing, inside which a magnetic component is arranged, or may be a radiator assisting heat dissipation of the enclosure, or may be other functional devices provided for the enclosure 1. In addition, the grounding structure specifically includes at least one grounding connection portion 3 that is provided on a housing wall of the part of the functional device 2 outside the enclosure, and the housing wall of the functional device 2 is electrically connected to the enclosure 1.

With this grounding structure, in actual applications, the grounding connection portion 3 is arranged on the housing wall of the functional device 2, where the housing wall of the functional device 2 is electrically connected to the enclosure 1. Therefore, the grounding demand of the enclosure 1 of the electrical equipment is satisfied without occupation of an internal space of the enclosure 1, i.e. there is no need to take a safety space (such as an electrical clearance, a creepage distance, or the like) between the grounding connection portion 3 and an electrical device inside the enclosure 1 into consideration, which is beneficial to the miniaturization of the enclosure.

It should be noted that, the grounding structure generally includes a grounding symbol 4. The grounding symbol 4 is provided on the outer housing wall of the functional device 2 at a position proximate to the grounding connection portion 3, which facilitates grounding operations of a user or an operator.

It should also be noted that, the number of the grounding connection portion 3 may be one, or may be plural, such as two. In actual applications, the number of the grounding connection portion may be selected according to actual needs, which is not specifically limited herein.

Moreover, the grounding connection portion 3 may be a grounding threaded hole in cooperation with a grounding bolt and a grounding cable for connection with the ground, or the grounding connection portion 3 may be a grounding screw in cooperation with a grounding nut and a grounding cable for connection with the ground. Certainly, it may be appreciated that, the cases that the grounding connection portion 3 employs the grounding threaded hole or the grounding screw are merely examples of the present application. In actual applications, the grounding connection portion may employ other forms usually used by those skilled in the art, such as a grounding piece or a grounding wire clip, which may be provided according to actual needs, and is not specifically limited herein.

In a further embodiment, referring to FIG. 2, to save a length of the grounding cable, specifically, the grounding connection portion 3 is arranged at a side of the housing wall of the functional device 2 at a position proximate to a bottom of the housing wall. Certainly, it may be appreciated that, the above case that the grounding connection portion 3 is arranged at the side of the housing wall of the functional device 2 at a position proximate to the bottom thereof is merely an example of the present application. In actual applications, the grounding connection portion 3 may be provided at other positions according to arrangement needs. For example, the grounding connection portion 3 may be provided at a bottom side of the outer housing wall, which is not specifically limited herein.

In some specific embodiments, the functional device 2 may be a die-casting piece, or may be a machined piece, a 3D-printed piece, a profile piece or the like. In actual applications, the functional device 2 may be manufactured by corresponding processing methods according to actual needs, which is not specifically limited herein.

It should be noted that, the grounding connection portion 3 and the functional device 2 may be designed as a one-piece structure, or separate structures that are fixedly connected to each other. In actual applications, the way in which the grounding connection portion 3 being formed on the functional device 2 may be selected in correspondence to the specific structural form of the grounding connection portion 3. When the grounding connection portion 3 is the grounding screw, the grounding connection portion 3 and the functional device 2 may be separate structures that are fixedly connected. For example, the grounding connection portion 3 is connected to the functional device 2 by welding, alternatively, the grounding connection portion 3 and the functional device 2 may be of a one-piece structure. When the grounding connection portion 3 is the grounding threaded hole, the grounding connection portion 3 and the functional device 2 are preferably integrally formed into a one-piece structure. For example, the threaded hole is formed by machining.

In a further embodiment, when the grounding structure includes both the grounding connection portion 3 and the grounding symbol 4, at least one of the grounding connection portion 3 and the grounding symbol 4 is configured to be integrally formed into one piece with the functional device 2. That is, one of the grounding connection portion 3 and the grounding symbol 4 may be integrally formed into one piece with the functional device 2 (for example, being molded by die-casting), and the other one is provided on the functional device 2 by additional installation or post-processing; alternatively, both the grounding connection portion 3 and the grounding symbol 4 are integrally molded into one piece with the functional device 2, which may be selected according to actual needs in actual applications. For example, in a case that the functional device 2 is a die-casting piece, the grounding connection portion 3 (such as the grounding threaded hole (referring to FIGS. 1 and 2) or the grounding screw (referring to FIG. 3)) and the grounding symbol 4 may both be formed by molding, in this case, there is no need of additional mounting and fixing process for other parts, which can reduce the number of the parts, processes, and processing time, and thereby decreasing the total cost.

In some specific embodiments, the grounding symbol 4 may be in a structural form of a protrusion or a recess that is formed on the outer housing wall of the functional device 2. With this structure, the grounding symbol 4 is less likely to be damaged by long-term influence of the external environment, leading to a longer service life.

It should be noted that, specifically, the grounding symbol 4 is provided on the outer housing wall by stamping, laser marking, labeling, or printing. In actual applications, the processing and arrangement manners may be selected according to actual needs, which are not specifically limited herein.

Moreover, electrical equipment is provided according to the present application, including the grounding structure according to any one of the above solutions. Since the grounding structure has the above technical effects, the electrical equipment having the grounding structure also has corresponding technical effects, which are not described herein.

In a further embodiment, specifically, the electrical equipment may be electrical equipment that is used for photovoltaic power generation, such as an inverter, a rectifier, a combiner box or the like, as long as the electrical equipment is required to be grounded and has a functional device, which is not specifically limited herein.

It should be noted that, the embodiments in this specification are described in a progressive manner. Each of the embodiments is mainly focused on describing its differences from other embodiments, and references may be made among these embodiments with respect to the same or similar portions among these embodiments.

It should be understood that, the use of terms "system", "device", "unit" and/or "module" in this application is only intended for distinguishing different components, elements, parts, portions or assemblies at different levels. However, if the same purpose can be realized by other words, the terms may be replaced by other expressions.

As described in the present application and the claims, unless exceptional cases explicitly indicated in the content, terms "a", "one", "a type" and/or "the" are not intended to refer to a single one, instead, they may include a plural case. In general, terms "include" and "comprise" are intended to include merely explicitly identified steps and elements. The steps and elements are not intended to form an exclusive list, and the method or the device may include other steps and elements. An element defined by a sentence "include a..." does not exclude a case that there is another same element in the process, method, product or device including the element.

In the descriptions in the embodiments of the present application, unless otherwise noted, "/" indicates the meaning of "or". For example, A/B may indicate A or B. The term "and/or" herein is only intended to describe correlation relationships between correlated objects, and indicates there may be three correlation relationships. For example, the term "A and/or B" indicates three cases, namely only A exists, both A and B exist, and only B exists. In addition, in the descriptions in the embodiments of the present application, the term "multiple" indicates two or more.

The terms such as "first", "second" and the like are merely for description, and should not be construed as indicating or implying relative importance, or implicitly indicating the number of technical features being referred to. In this way, the feature defined by the terms "first", "second" may explicitly or implicitly include one or more such features.

If a flowchart is used in the present application, this flowchart is intended to illustrate the operation performed by the system according to the embodiment of the application. It should be understood that, the preceding and following operations may not be exactly performed in sequence. On the contrary, the steps may be processed in reverse order or simultaneously. Moreover, other operations may be added to these processes, or a certain step or several steps of operation can be removed from these processes.

The principle and the embodiments of the present application are illustrated herein by specific embodiments. The above description of embodiments is only intended to help the understanding of the idea of the present application. It should be noted that, for those skilled in the art, some improvements and modifications may be made to the present application without departing from the principle of the present application, and these modifications and improvements are also deemed to fall into the protection scope of the present application defined by the claims.

## Claims

1. A grounding structure, applicable to electrical equipment having an enclosure (1) to be grounded and a functional device (2), at least part of the functional device (2) being located at an outer side of the enclosure (1), wherein
the grounding structure comprises at least one grounding connection portion (3) configured to be arranged on a housing wall of the at least part of the functional device (2) located at the outer side of the enclosure (1); and
the housing wall of the functional device (2) is electrically connected to the enclosure (1).

2. The grounding structure according to claim 1, further comprising a grounding symbol (4) that is provided on the housing wall of the at least part of the functional device (2) located at the outer side of the enclosure (1) at a position proximate to the grounding connection portion (3).

3. The grounding structure according to claim 1, wherein the grounding connection portion (3) is a grounding threaded hole configured to cooperate with a grounding bolt and a grounding cable for connection with the ground, or the grounding connection portion (3) is a grounding screw configured to cooperate with a grounding nut and a grounding cable for connection with the ground.

4. The grounding structure according to claim 1, wherein the grounding connection portion (3) is arranged at a side of the housing wall of the functional device (2) at a position proximate to a bottom thereof.

5. The grounding structure according to claim 1, wherein the functional device (2) is a die-casting piece, a machined piece, a 3D-printed piece or a profile piece.

6. The grounding structure according to claim 5, wherein the grounding connection portion (3) and the functional device (2) are integrally formed into one piece or are separate structures that are fixedly connected.

7. The grounding structure according to claim 2, wherein at least one of the grounding connection portion (3) and the grounding symbol (4) is configured to be integrally formed into one piece with the functional device (2).

8. The grounding structure according to claim 2, wherein the grounding symbol (4) is a protrusion or a recess formed on the housing wall.

9. The grounding structure according to claim 2, wherein the grounding symbol (4) is provided on the housing wall by stamping, laser marking, labeling or printing.

10. The grounding structure according to any one of claims 1 to 9, wherein the functional device (2) is an inductor housing.

11. Electrical equipment, comprising the grounding structure according to any one of claims 1 to 10.

12. The electrical equipment according to claim 11, wherein the electrical equipment is configured to be applied in photovoltaic power generation.
